# EUROPEAN PATENT SPECIFICATION

(11) **EP 0 355 766 B1**
(45) Date of publication and mention of the grant of the patent: **04.05.1994**
(21) Application number: 89115378.5
(22) Date of filing: 21.08.1989
(51) Int. Cl.: G11B 5/85, C23C 14/30, C23C 14/56, H01J 37/317, H01J 37/06

(54) **Vacuum deposition apparatus and process for preparing magnetic recording medium**
Vorrichtung zur Vakuumsniederschlagung und Verfahren zur Herstellung von magnetischem Aufzeichungsträger
Appareil de déposition dans le vide et procédé pour préparer un support d'enregistrement magnétique

(30) Priority: 26.08.1988 JP 212066/88
(43) Date of publication of application: 28.02.1990
(73) Proprietor: Hitachi Maxell Ltd., Osaka-fu (JP)
(72) Inventor: Niimi, Hideaki, Tsuchiura-shi (JP); Mizumura, Tetsuo, Kitasoma-gun Ibaraki-ken (JP); Isoe, Noboru, Toride-shi (JP)
(74) Representative: Beetz & Partner Patentanwälte

(56) References cited:
- US-A- 4 601 912
- US-A- 4 604 293
- PATENT ABSTRACTS OF JAPAN vol. 007, no. 066 (C-157) 18 March 1983;& JP-A-58001074
- PATENT ABSTRACTS OF JAPAN vol. 010, no. 292 (C-376) 03 October 1986;& JP-A-61106731
- PATENT ABSTRACTS OF JAPAN vol. 012, no. 252 (C-512) 15 July 1988;& JP-A-63038578

## Description

### BACKGROUND OF THE INVENTION

The present invention relates to an electron beam heating vacuum deposition apparatus. In more particular, the invention relates to an electron beam heating vacuum deposition apparatus having an improved electron beam generating mechanism and to a process for preparing a magnetic recording medium using said apparatus.

A metal film type magnetic recording medium obtained by forming a film of a ferromagnetic material on a non-magnetic substrate by means of vacuum deposition has advantages in that, since it contains no non-magnetic binder incorporated in its magnetic layer, it can give a very high residual magnetic flux density and that, since its magnetic layer can be formed very thinly, it can afford a high output and is excellent in high density recording characteristics. By virtue of these features, the metal film type magnetic recording medium is becoming the mainstream of magnetic recording media in these days.

"Vacuum deposition" is a process which comprises heating a ferromagnetic metal in vacuo to vaporize or sublimate it, and adhering and condensing the resulting metal vapor onto a non-magnetic substrate to form a thin film.

One of the methods of heating a ferromagnetic metal is the method of heating by electron beam. In this method, a ferromagnetic material is molten and vaporized by means of an electron beam and formed into film. As compared with the resistance heating method, it is advantageous in that even materials of high melting points can be vapor-deposited by this method.

US-A-4 601 912 discloses an electron beam heating apparatus and process with the precharacterizing features of claims 1 and 3, respectively, without indicating the material of the cathode for generating the electron beam.

JP-A-58 001 074 discloses the use of a tantalum or tungsten electrode in a vapor deposition apparatus based on a resistance heating system.

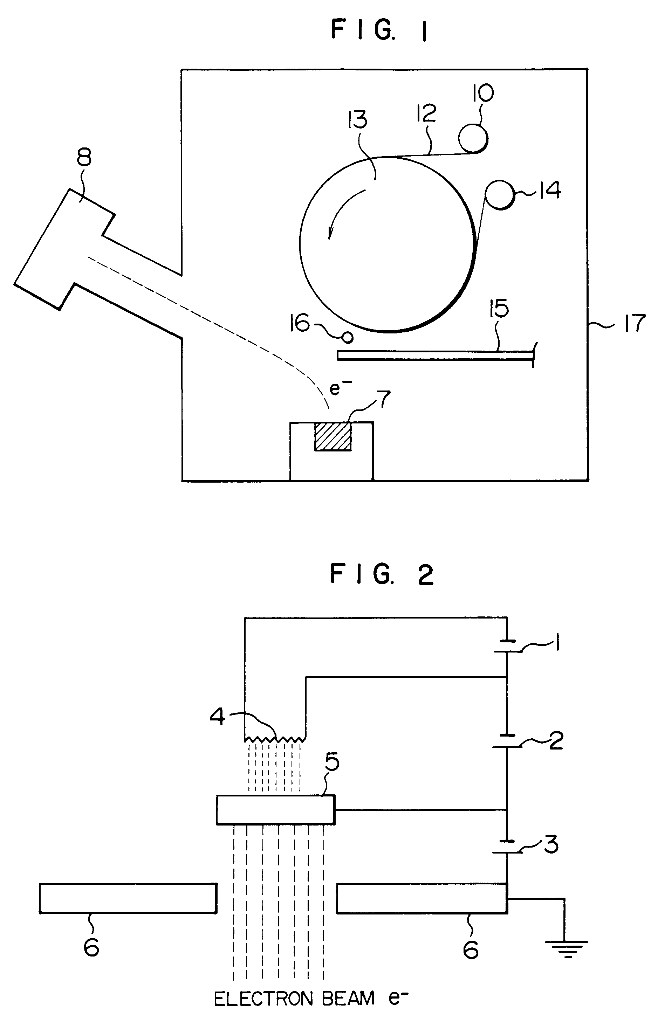

A schematic diagram of one example of a conventionally used electron beam generating mechanism is shown in Fig. 2.

In Fig. 2, numerals 1, 2 and 3 indicate electric sources. The electric source 1 is of DC 5-300 V, more specifically 30 V, source 2 DC 0.5-10 KV, more specifically 3 KV and source 3 DC 5-500 KV, more specifically 30 KV. Numeral 4 indicates a filament, numeral 5 a cathode and numeral 6 an anode. The voltages of electric sources mentioned above merely represent an example and may be varied widely according to the use and capacity of the electron beam generating mechanism.

In the electron beam generating mechanism shown in the Figure, an electric current is applied from the electric source 1 to the filament 4 to generate thermoelectrons, and the thermoelectrons are accelerated by a voltage of 3 KV with the electric source 2 and irradiated to the cathode 5 consisting, for example, of tungsten to heat the cathode. An electron beam is obtained from the cathode 5, accelerated by a voltage of 30 KV between the cathode 5 and the anode 6.

However, such an electron beam generating mechanism has had a problem in that the applied high voltage causes residual gases in the vacuum vessel to give rise to an ionization discharge between the cathode 5 and the anode 6, leading to momentary stoppage of electron beam generation. It has been observed that such abnormal discharge occurs particularly frequently when an oxidizing gas is present in the vacuum vessel.

When such abnormal discharge occurs frequently, since vapor deposition stops each time, the uniformity of film thickness distribution deteriorates and the decrease in yield or in throughput results.

Accordingly, the object of the present invention is to ameliorate the defect of the prior art mentioned above, namely the occurrence of abnormal discharge, and to provide an electron beam heating vacuum deposition apparatus and process having an electron beam generating mechanism capable of generating an electron beam more continuously.

### SUMMARY OF THE INVENTION

To attain the above-mentioned object, according to the present invention, there is provided an electron beam heating vacuum deposition apparatus as claimed in claim 1.

The vacuum deposition apparatus of the present invention is usually operated at a degree of vacuum of 1.33·10⁻³ - 1.33·10⁻⁸ hPa (10⁻³ - 10⁻⁸ Torr). When metal oxides such as titanium oxide and aluminum oxide are to be formed, the vacuum deposition is performed while introducing an oxidizing gas such as oxygen, water or carbon dioxide into the vapor deposition apparatus to give a partial pressure of the oxidizing gas of usually 1.33·10⁻³ - 1.33·10⁻⁸ hPa (10⁻³ - 10⁻⁸ Torr).

In the electron beam generating mechanism, the voltage of electric source applied to the filament, that between the filament and the cathode, and that between the cathode and the anode are usually 5-300 V, 0.5-10KV, and 5-500 KV, respectively.

Examples of vaporization sources which may be advantageously used include, besides Al, Ti and Cr, Fe, Ni, Co and alloys thereof, e.g. Fe-Co, Ni-Fe, Ni-Co, Ni-Mn, Ni-Al, Co-Ni, and Co-Cr alloys.

The electron beam generating body preferably comprises 95 - 100 at % of tantalum and 5 - 0 at % of tungsten.

Further, according to the present invention, there is provided a process for preparing a magnetic recording medium as claimed in claim 3.

The process of the present invention is particularly effective in vapor deposition of a ferromagnetic metal onto a non-magnetic substrate in an atmosphere containing an oxidizing gas such as oxygen, water or carbon dioxide.

Examples of ferromagnetic metals commonly used in magnetic recording media include Fe, Co, and Fe-Co, Fe-Ni, Co-Ni, and Co-Cr alloys. The process according to the present invention can be effectively used in the vapor deposition of these metals. The present process is particularly useful in vapor-depositing Co-Ni alloy and the like materials in an oxygen-containing gas. It is needless to say that in the present process for preparing magnetic recording media, the same conditions including the degree of vacuum and the partial pressure of oxidizing gas may be used as those in the vacuum deposition described above.

### BRIEF DESCRIPTION OF THE DRAWING

Fig. 1 is a schematic diagram showing one example of vacuum deposition apparatuses of electron beam heating type used in the Example of the present invention for preparing a magnetic recording medium. Fig. 2 is a schematic diagram showing one example of an electron beam generating mechanism.

### DETAILED DESCRIPTION OF THE INVENTION

As described above, the electron beam generating body in the vacuum deposition apparatus of the present invention comprises tantalum as the principal component in place of tungsten priorly used. Consequently, the vacuum deposition apparatus of the present invention scarcely gives rise to abnormal discharge even when used in an atmosphere containing an oxidizing gas.

According to the study of the present inventors, in an atmosphere containing an oxidizing gas the prior art tungsten cathode comes to more difficultly generate an electron beam owing to the oxidation of the tungsten surface. Consequently, the tungsten cathode should be brought to a higher temperature than usual to obtain a desired electron dose. However, it is thought that when the tungsten cathode is brought to a high temperature, surrounding gases (e.g., adsorbed water) come out, causing abnormal discharge to occur. When abnormal discharge occurs between the cathode and the anode, the generation of electron beam stops during the time.

After extensive trial manufacture and experiments repeated by the present inventors, it has been found that the occurrence of abnormal discharge in an oxidizing gas atmosphere can be effectively suppressed by using a substance containing at least 95 at % of tantalum as the electron beam generating body (namely, cathode).

Tantalum should be contained in a proportion of at least 95 at %. At a proportion below said value, the effect of suppressing abnormal discharge occurrence cannot be expected. Besides tantalum, 5 at % or less of tungsten may be incorporated for the purpose of improying heat resistance. Other metals than tungsten (e.g., molybdenum) may also be used so long as it is electroconductive.

### DESCRIPTION OF THE PREFERRED EMBODIMENTS

### Example

The present invention will be described in further detail below with reference to Examples.

A magnetic recording medium was prepared by continuous vapor deposition using a vacuum deposition apparatus as shown in Fig. 1. In Fig. 1, numeral 7 indicates a ferromagnetic metal vaporization source comprising a Co-Ni (80:20) alloy, 8 an electron beam generating mechanism, 10 a feed roll, 12 a polymer film substrate, 13 a can roll, 14 a take-up roll, 15 an antisticking plate, 16 an oxygen gas inlet, and 17 a vacuum vessel.

An electron beam generating mechanism as shown in Fig. 2 was used. Electric current was passed through a tungsten filament 4 to generate thermoelectrons. The thermoelectrons were accelerated by a voltage of 3 KV and irradiated to a cathode 5 to heat it. An electron beam was obtained from the cathode 5, accelerated by a voltage of 30 KV.

During vapor deposition, oxygen gas was introduced from the oxygen gas inlet to maintain the oxygen partial pressure in the vacuum vessel at 1.33 x 10⁻⁴ hPa (1 x 10⁻⁴ Torr). The electron dose was 3 A.

Magnetic recording media were prepared by using cathodes of various compositions.

Table 1 below shows the compositions of cathodes used and the number of times of abnormal discharge occurrence in 3 hours of continuous vapor deposition.

**Table 1**

| Composition (at %) | | Number of times of abnormal discharge occurence |
|---|---|---|
| Tantalum | Tungsten | |
| 100 | 0 | 1 |
| 98 | 2 | 2 |
| 96 | 4 | 2 |
| 94 | 6 | 5 |
| 92 | 8 | 7 |
| 90 | 10 | 7 |
| 0 | 100 | 10 |

As is apparent from the above results, the use of a cathode comprising at least 95 at % of tantalum enables a marked suppression of occurrence of abnormal discharge.

As described above, the cathode used in the electron beam generating mechanism in the vacuum deposition apparatus of the present invention comprises tantalum as the principal component in place of conventionally used tungsten. Consequently, the electron beam generating mechanism of the present invention scarcely gives rise to abnormal discharge even when used in an atmosphere containing an oxidizing gas.

Resultantly, not only the energy efficiency but also the throughput in thin film preparation is improved. Further, the quality of film formed is improved and the uniformity of film thickness is enhanced.

## Claims

1. An apparatus for vacuum vapor deposition of a ferromagnetic metal onto a non-magnetic substrate (12) with an electron beam in an oxidizing gas atmosphere,
**characterized** in that
a cathode (5) for generating the electron beam comprises at least 95 % by atom of tantalum.

2. An apparatus according to claim 1, wherein the cathode (5) comprises 95 - 100 at % of tantalum and 5 - 0 at % of tungsten.

3. A process for preparing a magnetic recording medium by vacuum vapor deposition of a ferromagnetic metal onto a non-magnetic substrate (12) with an electron beam in an oxidizing gas atmosphere,
characterized by
using an electron beam generating body (5) comprising at least 95 % by atom of tantalum as a cathode.

4. A process according to claim 3, wherein the electron beam generating body (5) comprises 95 - 100 at % of tantalum and 5 - 0 % of tungsten.

5. An apparatus according to claim 1, wherein the degree of vacuum is 1.33·10⁻³ - 1.33·10⁻⁸ hPa (10⁻³ - 10⁻⁸ Torr).

6. An apparatus according to claim 1, wherein the partial pressure of the oxidizing gas is 1.33·10⁻³ - 1.33·10⁻⁸ hPa (10⁻³ - 10⁻⁸ Torr).

7. An apparatus according to claim 1, wherein a voltage of 5 - 500 KV is applied between an anode and the cathode (5).

8. A process according to claim 4, wherein the partial pressure of the oxidizing gas is 1.33·10⁻³ - 1.33·10⁻⁸ hPa (10⁻³ - 10⁻⁸ Torr).

9. A process according to claim 3, wherein the ferromagnetic metal is Fe, Ni, Co, or the alloy thereof.

10. A process according to claim 4, wherein the oxidizing gas is oxygen gas.

11. A process according to claim 10, wherein the ferromagnetic metal is Co or the alloy thereof.

## Patentansprüche

1. Vorrichtung zur Vakuumdampfabscheidung eines ferromagnetischen Metalls auf einem nichtmagnetischen Substrat (12) mit einem Elektronenstrahl in einer oxidierenden Gasatmosphäre,
**dadurch gekennzeichnet,**
daß eine Kathode (5) zur Erzeugung des Elektronenstrahls wenigstens 95 Atom-% Tantal aufweist.

2. Vorrichtung nach Anspruch 1,
wobei die Kathode (5) 95 - 100 Atom-% Tantal und 5 - 0 Atom-% Wolfram aufweist.

3. Verfahren zur Herstellung eines magnetischen Aufzeichnungsmediums durch Vakuumdampfabscheidung eines ferromagnetischen Metalls auf einem nichtmagnetischen Substrat (12) mit einem Elektronenstrahl in einer oxidierenden Gasatmosphäre,
**gekennzeichnet durch**
Verwendung eines Elektronenstrahl-Erzeugungskörpers (5), der wenigstens 95 Atom-% Tantal aufweist, als Kathode.

4. Verfahren nach Anspruch 3,
bei dem der Elektronenstrahl-Erzeugungskörper (5) 95 - 100 Atom-% Tantal und 5 - 0 Atom-% Wolfram aufweist.

5. Vorrichtung nach Anspruch 1,
wobei der Vakuumgrad 1,33 · 10⁻³ - 1,33 · 10⁻⁸ hPa (10⁻³ - 10 ⁻⁸Torr) ist.

6. Vorrichtung nach Anspruch 1,
wobei der Partialdruck des oxidierenden Gases 1,33 · 10⁻³ - 1,33 · 10⁻⁸ hPa (10⁻³ - 10⁻⁸ Torr) ist.

7. Vorrichtung nach Anspruch 1,
wobei eine Spannung von 5 - 500 V zwischen einer Anode und der Kathode (5) angelegt wird.

8. Verfahren nach Anspruch 4,
bei dem der Partialdruck des oxidierenden Gases 1,33 · 10⁻³ - 1,33 · 10⁻⁸ hPa (10⁻³ - 10⁻⁸ Torr) ist.

9. Verfahren nach Anspruch 3,
bei dem das ferromagnetische Metall Fe, Ni, Co oder die Legierung davon ist.

10. Verfahren nach Anspruch 4,
bei dem das oxidierende Gas Sauerstoffgas ist.

11. Verfahren nach Anspruch 10,
bei dem das ferromagnetische Metall Co oder dessen Legierung ist.

## Revendications

1. Appareil pour la déposition sous vide en phase vapeur d'un métal ferromagnétique sur un substrat non magnétique (12) par un faisceau électronique dans une atmosphère de gaz oxydant, caractérisé en ce qu'une cathode (5) contient au moins 95 % d'atomes de tantale pour produire le faisceau électronique.

2. Appareil selon la revendication 1, dans lequel la cathode (5) contient de 95 à 100 % de tantale et de 5 à 0 % de tungstène.

3. Procédé pour la préparation d'un support d'enregistrement magnétique par déposition sous vide en phase vapeur d'un métal ferromagnétique sur un substrat non magnétique (12) par un faisceau électronique dans une atmosphère de gaz oxydant, caractérisé par l'utilisation d'un corps (5) produisant le faisceau électronique en tant que cathode comprenant au moins 95 % d'atomes de tantale.

4. Procédé selon la revendication 3, dans lequel le corps (5) produisant le faisceau électronique contient de 95 à 100 % de tantale et de 5 à 0 % de tungstène.

5. Appareil selon la revendication 1, dans lequel le degré de vide est 1,33.10⁻³-1,33.10⁻⁸ hPa (10⁻³-10⁻⁸ Torr).

6. Appareil selon la revendication 1, dans lequel la pression partielle du gaz oxydant est 1,33.10⁻³-1,33.10⁻⁸ hPa (10⁻³-10⁻⁸ Torr).

7. Appareil selon la revendication 1, dans lequel une tension de 5-500 kV est appliquée entre l'anode et la cathode (5).

8. Procédé selon la revendication 4, dans lequel la pression partielle du gaz oxydant est 1,33.10⁻³-1,33.10⁻⁸ hPa (10⁻³-10⁻⁸ Torr).

9. Procédé selon la revendication 3, dans lequel le métal ferromagnétique est Fe, Ni, Co ou un de leurs alliages.

10. Procédé selon la revendication 4, dans lequel le gaz oxydant est le gaz oxygène.

11. Procédé selon la revendication 10, dans lequel le métal ferromagnétique est Co ou un de ses alliages.
